# FASCICULE DE BREVET EUROPEEN

(11) **EP 4 170 362 B1**
(45) Date de publication et mention de la délivrance du brevet: **18.06.2025**
(21) Numéro de dépôt: 22198064.2
(22) Date de dépôt: 27.09.2022
(51) Int. Cl.: G01R 31/12

(54) **PROCÉDÉ DE DÉTECTION D'ÉVÉNEMENT ANORMAL DANS UN CONDUCTEUR ÉLECTRIQUE D'UN APPAREIL ÉLECTRIQUE DE MOYENNE TENSION**
VERFAHREN ZUR ERKENNUNG ABNORMALER EREIGNISSE IN EINEM ELEKTRISCHEN LEITER EINES ELEKTRISCHEN MITTELSPANNUNGSGERÄTS
METHOD FOR DETECTING ABNORMAL EVENT IN AN ELECTRICAL CONDUCTOR OF A MEDIUM VOLTAGE ELECTRICAL APPARATUS

(30) Priorité: 25.10.2021 FR 2111325
(43) Date de publication de la demande: 26.04.2023
(73) Titulaire: Schneider Electric Industries SAS, 92500 Rueil-Malmaison (FR)
(72) Inventeur: BOGUSLAWSKI, Bartosz, 38100 Grenoble (FR); ALBERTO, Diego, 38700 Corenc (FR)
(74) Mandataire: Schneider Electric

(56) Documents cités:
- WO-A1-2020/160590
- FR-A1- 3 086 059

## Description

### Domaine technique

La présente invention se rapporte au domaine des appareils électriques à moyenne tension ou à haute tension.

### Technique antérieure

Les appareils électriques opérant sous moyenne tension ou haute tension peuvent être sujet à évènements anormaux au cours de leur fonctionnement. Un exemple d'évènement anormal est par exemple une ou des décharges partielles entre les conducteurs électriques et l'environnement avoisinant. On entend par décharge partielle une décharge électrique localisée dans une isolation électrique. La décharge est dite partielle car elle ne court-circuite pas l'ensemble de l'isolation. Ces décharges partielles peuvent se propager dans l'air, ou à l'intérieur même de la matière isolante. Ces décharges partielles n'affectent pas à court terme le fonctionnement de l'appareil électrique concerné, mais accélèrent le vieillissement des isolants. Lorsque les isolants sont trop endommagés, un arc électrique franc peut survenir, ce qui peut conduire à la destruction de l'appareil électrique et présenter des risques majeurs pour les personnes situées à proximité de l'appareil. Ainsi, les décharges partielles doivent être détectées afin de permettre une intervention avant un endommagement permanent, une destruction de l'appareil électrique concerné, et avant un incident de personne.

Diverses méthodes de détection des décharges partielles sont connues. L'une d'entre elles consiste à surveiller les décharges partielles localement, et repose sur une mesure des vibrations à la surface d'un isolant autour d'un conducteur électrique de l'appareil électrique. Pour cela, un capteur de mesure de vibration est disposé sur l'isolant d'un conducteur électrique de l'appareil électrique. Une méthode de traitement du signal basée sur un traitement statistique des mesures réalisées permet de déterminer les évènements correspondant à une décharge partielle.

Une telle méthode comporte cependant des limitations. En particulier, sa précision est en général limitée à cause de l'amplitude significative du bruit environnant en regard de celui de la décharge partielle quand cette dernière est plutôt de faible amplitude. Ainsi, le taux de fausse détection ainsi que le taux de non-détection sont relativement élevés.

FR 3 086 059 A1 divulgue un procédé de surveillance du fonctionnement d'une machine générant des vibrations, ce procédé comportant une phase d'apprentissage et une phase de surveillance.

Il existe donc un besoin de disposer d'une méthode de détection d'évènement anormal telle une décharge partielle assurant une précision améliorée, avec en particulier un taux de non-détection et un taux de fausse détection qui soient tous les deux réduits.

### Résumé

A cette fin, l'invention selon la revendication 1 propose un procédé de détection d'événement anormal dans un isolant d'un conducteur électrique d'un appareil électrique de moyenne tension ou de haute tension,
le procédé comportant les étapes :
   - acquérir un ensemble d'échantillons successifs d'un signal vibratoire associé au conducteur électrique,
   - déterminer une valeur modélisée d'un échantillon suivant à partir de l'ensemble d'échantillons acquis et d'un modèle de prédiction,
le modèle de prédiction étant obtenu par apprentissage automatique du signal vibratoire à partir d'un ensemble d'échantillons acquis dans des conditions de référence dans lesquelles le conducteur électrique est exempt d'évènement anormal,
   - acquérir l'échantillon suivant du signal vibratoire,
   - calculer une différence entre la valeur de l'échantillon acquis et la valeur modélisée,
   - Si la différence calculée est supérieure à un seuil prédéterminé, détecter un évènement anormal dans le conducteur électrique.

La détection d'un évènement anormal dans le conducteur électrique repose à la fois sur une mesure réellement mesurée d'un signal vibratoire associé au conducteur électrique et sur un modèle calculant l'évolution attendue du signal vibratoire. Un écart trop grand entre le signal modélisé et le signal réellement mesuré indique que l'évènement anormal à détecter s'est produit. Le modèle de prédiction étant obtenu par apprentissage automatique, celui-ci peut ainsi être automatiquement adapté aux caractéristiques réelles de chaque équipement électrique pour lequel le procédé est mis en œuvre. Les dispersions entre équipements sont ainsi prises en compte automatiquement, ce qui facilite la mise au point du procédé ainsi que son efficacité.

L'apprentissage automatique est réalisé à partir d'un ensemble d'échantillons acquis dans des conditions de référence dans lesquelles le conducteur électrique est exempt d'évènement anormal. L'apprentissage automatique est ainsi réalisé à partir d'un ensemble d'échantillons dans lequel l'évènement anormal à détecter est absent. L'ensemble des valeurs possibles du signal vibratoire en absence de l'évènement anormal à détecter peut ainsi être caractérisé, et correspond au bruit nominal du signal vibratoire en absence d'évènement anormal. L'apprentissage automatique du bruit nominal du signal vibratoire durant la phase de vie de l'appareil où il n'y a pas de décharge partielle permet d'améliorer la performance du procédé de détection, aussi bien pour le taux de non-détection que pour le taux de fausse détection de l'évènement anormal indésirable.

Cette méthode permet d'améliorer la précision de la détection par rapport aux méthodes classiques basées uniquement sur le traitement du signal mesuré.

Les caractéristiques listées dans les paragraphes suivant peuvent être mises en œuvre indépendamment les unes des autres, ou selon toutes les combinaisons techniquement possibles :

Selon un aspect du procédé, le procédé comporte l'étape :
- Si la différence calculée est inférieure ou égale au seuil prédéterminé, détecter une absence d'évènement anormal dans le conducteur électrique.

Selon un mode de réalisation, l'événement anormal détecté est une décharge partielle.

En variante ou en complément, l'évènement anormal peut être un choc mécanique affectant le fonctionnement de l'appareil. Par exemple, l'évènement anormal peut être un démarrage intempestif d'un moteur électrique ou des chocs mécaniques provoqués par ce moteur.

Une décharge partielle n'entraine pas à court terme de défaillance de l'appareil électrique, mais il est souhaitable de détecter l'occurrence d'un tel évènement afin d'éviter une défaillance à long terme.

Selon un mode de réalisation, le signal vibratoire est un signal de vibration représentatif d'une vibration de l'isolant du conducteur électrique.

Selon un autre mode de réalisation, le signal vibratoire est un signal acoustique conduit dans l'isolant du conducteur électrique.

Selon un mode de réalisation, l'acquisition des échantillons successifs du signal vibratoire est réalisée avec une fréquence d'échantillonnage fixe.

En variante, l'acquisition des échantillons successifs du signal vibratoire peut être réalisée avec une fréquence d'échantillonnage variable.

Selon un mode de réalisation, la fréquence échantillonnage est comprise entre 1 kHz et 1000 kHz.

Le procédé peut comporter l'étape :
- vérifier que l'ensemble des échantillons utilisés pour l'apprentissage automatique est conforme à un fonctionnement exempt d'évènement anormal.

Le processus d'apprentissage automatique n'est ainsi pas perturbé par des échantillons non conformes.

Selon un autre aspect, les conditions de références dans lesquelles l'apprentissage automatique est réalisé sont une période de fonctionnement débutant à la première mise en service de l'appareil électrique et de durée égale à une première durée d'utilisation prédéterminée de l'appareil électrique.

Selon un mode de réalisation, la première durée d'utilisation prédéterminée est comprise entre 10 heures et 20 heures.

Selon un mode de réalisation, les conditions de références dans lesquelles l'apprentissage automatique est réalisé sont une période de fonctionnement débutant à la première mise en service du conducteur électrique et de durée égale à une deuxième durée d'utilisation prédéterminée de l'appareil électrique.

Selon un aspect, l'apprentissage automatique est réinitialisé en cas de remplacement du conducteur électrique.

Les paramètres de l'apprentissage automatique sont mémorisés dans une mémoire permanente de l'unité électronique de contrôle.

La durée d'acquisition de l'ensemble d'échantillons acquis dans des conditions de référence est supérieure à 5 secondes, par exemple supérieure à 20 secondes.

Cette durée d'acquisition permet d'obtenir un modèle suffisamment précis avec une durée d'apprentissage raisonnable.

Selon un exemple de mise en œuvre du procédé, l'ensemble d'échantillons successifs du signal vibratoire pris en compte pour déterminer une valeur modélisée de l'échantillon suivant comprend un nombre fixe d'échantillons, le nombre fixe d'échantillons étant compris entre 10 et 20.

Par exemple, la valeur modélisée de l'échantillon suivant est obtenue à partir des 15 échantillons préalablement acquis.

Selon un mode de réalisation, l'ensemble d'échantillons successifs du signal vibratoire pris en compte pour déterminer une valeur modélisée de l'échantillon suivant peut comprendre un nombre variable d'échantillons compris entre 4 et 20.

Selon un mode de réalisation, le procédé comporte l'étape :
- si un événement anormal est détecté dans l'isolant du conducteur électrique, incrémenter un compteur d'événement anormal.

Le compteur d'événement anormal peut ainsi être un compteur de décharge partielle.

Selon un mode de réalisation, le procédé comporte l'étape :
- si un événement anormal est détecté dans l'isolant du conducteur électrique, calculer une fréquence d'apparition de l'événement anormal, la fréquence d'apparition de l'événement anormal étant égale au rapport de la valeur du compteur d'événement anormal et du nombre d'échantillons acquis.

La fréquence d'apparition de l'événement anormal peut ainsi être une fréquence de décharge partielle. Autrement dit, la fréquence d'apparition de l'évènement anormal est dans ce cas un taux d'occurrence de décharge partielle dans le conducteur électrique.

Selon un aspect du procédé, le procédé comporte l'étape :
- si la fréquence d'apparition de l'événement anormal atteint un deuxième seuil prédéterminé, émettre un signal d'alerte.

Selon une variante de mise en œuvre, le procédé comporte l'étape :
- si le compteur d'événement anormal atteint un troisième seuil prédéterminé, émettre un signal d'alerte.

Selon un mode de réalisation, le troisième seuil prédéterminé Nmax du nombre d'événements anormaux acceptables est égal à 1.

Autrement dit, dans ce cas aucun évènement anormal n'est toléré et les utilisateurs de l'appareil sont avertis dès la première apparition d'un évènement anormal.

Selon un mode de réalisation, le troisième seuil prédéterminé Nmax du nombre d'événements anormaux acceptables est compris entre 2 et 5.

Selon un exemple de mise en œuvre, le signal d'alerte est un code défaut mémorisé dans une unité électronique de contrôle.

Selon une variante ou de manière complémentaire, le signal d'alerte est un allumage d'un voyant.

Selon une autre variante ou de manière complémentaire, le signal d'alerte est un signal sonore.

Selon un mode de réalisation, si le compteur d'événement anormal atteint le troisième seuil prédéterminé ou si la fréquence d'apparition de l'événement anormal atteint le deuxième seuil prédéterminé, un procédé de classification de l'évènement anormal est initié.

L'invention se rapporte également à un appareil électrique de moyenne tension ou de haute tension, l'appareil électrique comportant :
- un conducteur électrique,
- un capteur configuré pour fournir un signal vibratoire associé à un isolant du conducteur électrique,
- une unité électronique de contrôle configurée pour mettre en œuvre le procédé de détection selon la revendication 1.

Selon un mode de réalisation, le capteur est configuré pour fournir un signal représentatif d'une accélération de l'isolant du conducteur électrique.

Le capteur d'accélération est fixé à une surface extérieure du conducteur électrique.

Le capteur d'accélération est un capteur de type piézo-électrique.

Selon un mode de réalisation, la bande passante du capteur de vibration est comprise entre 1 kHz et 1000 kHz.

Selon un exemple de mise en œuvre du procédé, le capteur d'accélération délivre un signal analogique.

En variante, le capteur d'accélération délivre un signal numérique.

### Brève description des dessins

D'autres caractéristiques, détails et avantages apparaîtront à la lecture de la description détaillée ci-après, et à l'analyse des dessins annexés, sur lesquels :
[Fig. 1] est une représentation schématique d'un appareil électrique sur lequel le procédé selon l'invention est mis en œuvre,
[Fig. 2] est une représentation schématique de détail de l'appareil électrique de la figure 1,
[Fig. 3] est une représentation schématique de l'évolution temporelle de paramètres d'un mode de réalisation du procédé selon l'invention,
[Fig. 4] est une autre représentation de l'évolution temporelle de paramètres d'un mode de réalisation du procédé selon l'invention,
[Fig. 5] est une représentation temporelle illustrant une étape particulière d'un mode de réalisation du procédé selon l'invention,
[Fig. 6] est un schéma-bloc illustrant différentes étapes d'un mode de réalisation du procédé selon l'invention.

### Description des modes de réalisation

Afin de faciliter la lecture des figures, les différents éléments ne sont pas nécessairement représentés à l'échelle. Sur ces figures, les éléments identiques portent les mêmes références. Certains éléments ou paramètres peuvent être indexés, c'est-à-dire désignés par exemple par premier élément ou deuxième élément, ou encore premier paramètre et second paramètre, etc. Cette indexation a pour but de différencier des éléments ou paramètres similaires, mais non identiques. Cette indexation n'implique pas une priorité d'un élément, ou paramètre par rapport à un autre et on peut interchanger les dénominations. Quand il est précisé qu'un dispositif comporte un élément donné, cela n'exclut pas la présence d'autres éléments dans ce dispositif.

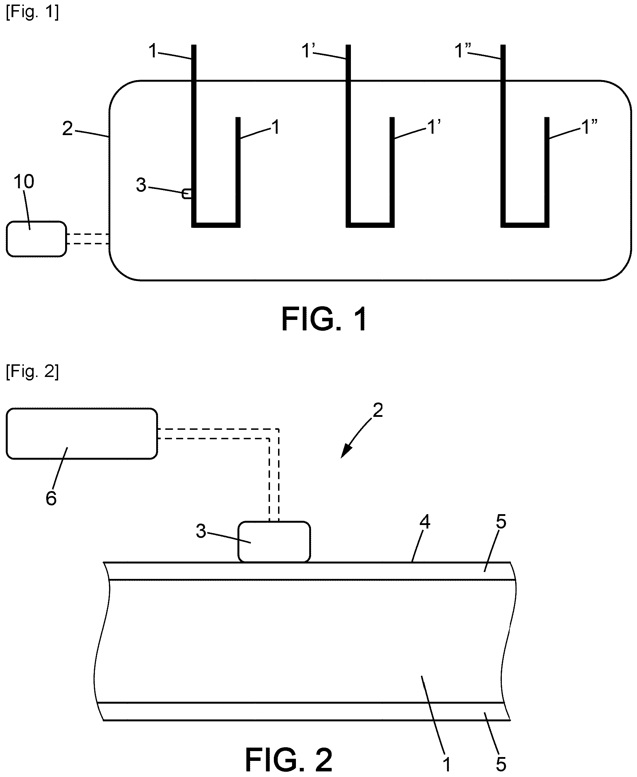

On a représenté sur la figure 1 un appareil électrique 2 de moyenne tension ou de haute tension, l'appareil électrique 2 comportant :
- un conducteur électrique 1,
- un capteur 3 configuré pour fournir un signal vibratoire V associé à un isolant 5 du conducteur électrique 1,
- une unité électronique de contrôle 10 configurée pour mettre en œuvre un procédé de détection selon l'invention.

L'appareil électrique 2 est un équipement à moyenne tension, c'est-à-dire une tension comprise entre 1 kV et 52 kV. L'appareil électrique 2 peut aussi être un équipement à haute tension. L'appareil électrique 2 peut être par exemple un disjoncteur, un sectionneur ou un interrupteur.

L'appareil électrique 2 comporte plusieurs conducteurs électriques. Par exemple, l'appareil électrique 2 comporte trois conducteurs électriques 1, 1', 1" correspondant aux trois phases d'un réseau électrique triphasé. Le procédé selon l'invention est être appliqué à chacun des conducteurs électriques 1, 1', 1".

Le procédé selon l'invention est un procédé de détection d'événement anormal dans un isolant 5 d'un conducteur électrique 1 d'un appareil électrique 2 de moyenne tension ou de haute tension. Le procédé comporte les étapes :
- acquérir un ensemble Sₙ d'échantillons successifs E₁, ..., Eₙ d'un signal vibratoire V associé au conducteur électrique 1, (étape 50)
- déterminer une valeur modélisée Mₙ₊₁ d'un échantillon suivant Eₙ₊₁ à partir de l'ensemble Sₙ d'échantillons acquis et d'un modèle de prédiction, (étape 51)
   le modèle de prédiction étant obtenu par apprentissage automatique du signal vibratoire V à partir d'un ensemble Vₚ d'échantillons acquis dans des conditions de référence CRef dans lesquelles le conducteur électrique 1 est exempt d'évènement anormal,
- acquérir l'échantillon suivant Eₙ₊₁ du signal vibratoire V, (étape 52)
- calculer une différence Dₙ₊₁ entre la valeur de l'échantillon acquis Eₙ₊₁ et la valeur modélisée Mₙ₊₁, (étape 53)
- Si la différence calculée Dₙ₊₁ est supérieure à un seuil prédéterminé Th, détecter un évènement anormal dans le conducteur électrique 1. (étape 54)

La détection d'un évènement anormal dans le conducteur électrique repose à la fois sur une valeur réellement mesurée d'un signal vibratoire associé au conducteur électrique, et sur un modèle calculant l'évolution attendue de ce signal vibratoire. Un écart trop grand entre le signal modélisé et le signal réellement mesuré indique que l'évènement anormal à détecter s'est produit. Le modèle de prédiction étant obtenu par apprentissage automatique, celui-ci peut ainsi être automatiquement adapté aux caractéristiques réelles de chaque équipement électrique pour lequel le procédé est mis en œuvre. Les dispersions entre équipements sont ainsi prises en compte automatiquement, ce qui facilite la mise au point du procédé ainsi que son efficacité.

L'apprentissage automatique est réalisé à partir d'un ensemble Vₚ d'échantillons acquis dans des conditions de référence CRef dans lesquelles le conducteur électrique 1 est exempt d'évènement anormal. L'apprentissage automatique est ainsi réalisé à partir d'un ensemble Vₚ d'échantillons dans lequel l'évènement anormal à détecter est absent. L'ensemble des valeurs possibles du signal vibratoire en absence de l'évènement anormal à détecter peut ainsi être caractérisé, et correspond au bruit nominal du signal vibratoire en absence d'évènement anormal. L'apprentissage automatique du bruit nominal du signal vibratoire durant la phase de vie de l'appareil où il n'y a pas de décharge partielle permet d'améliorer la performance du procédé de détection, aussi bien pour le taux de non-détection que pour le taux de fausse détection de l'évènement anormal indésirable. Ce procédé permet d'améliorer la précision de la détection par rapport aux méthodes classiques basées uniquement sur le traitement du signal mesuré.

Selon un aspect du procédé, le procédé comporte l'étape :
- Si la différence calculée Dn+1 est inférieure ou égale au seuil prédéterminé Th, détecter une absence d'évènement anormal dans le conducteur électrique 1.

Autrement dit, un faible écart entre le signal modélisé et le signal réellement mesuré indique qu'aucun évènement anormal ne s'est produit. Dans ce cas la détection d'absence d'évènement anormal est une confirmation que l'évènement anormal est absent, c'est-à-dire qu'il ne s'est pas produit.

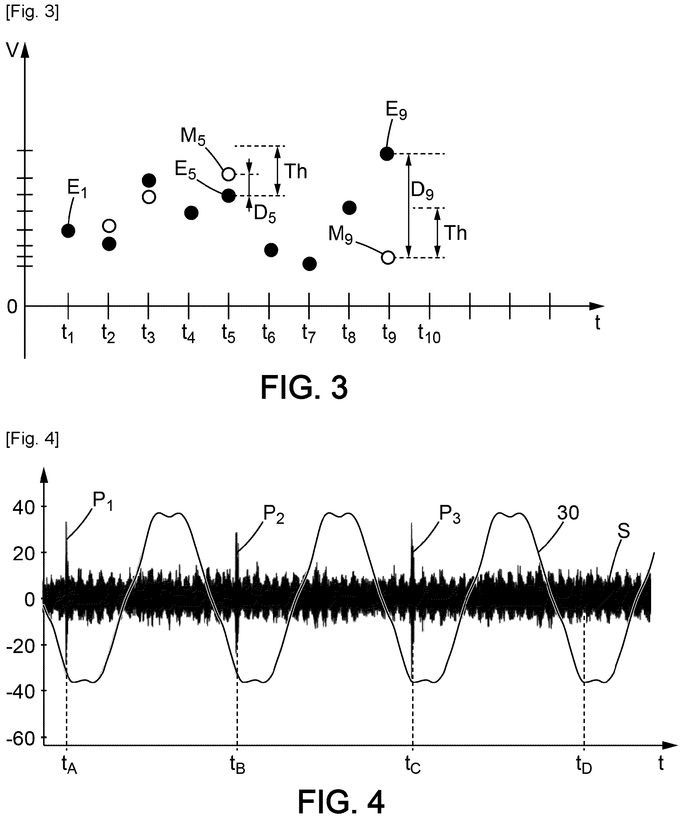

La figure 3 schématise le fonctionnement du procédé. Les échantillons de mesure successifs E₁, ..., Eₙ du signal vibratoire correspondent respectivement à des instants successifs de mesure t₁, ..., tₙ. Ainsi sur la figure 3, 10 instants de mesure t₁, ..., t₁₀ ont été représentés. Lorsqu'un ensemble Sₙ d'échantillons successifs E₁, ..., Eₙ a été acquis et que l'échantillon Eₙ est l'échantillon le plus récent, l'échantillon suivant Eₙ₊₁ correspond à la valeur de sortie fournie par le capteur vibratoire 3 à l'instant tₙ₊₁.

Le point E₁ représente la valeur du signal V mesurée à l'instant t₁. Le point E₅ représente la valeur du signal V mesurée à l'instant t₅, et le point E₉ représente la valeur du signal V mesurée à l'instant t₉. Le point M₅ représente la valeur modélisée de l'échantillon E₅, et de même le point M₉ représente la valeur modélisée de l'échantillon E₉. Afin de simplifier la figure, les points M₁ à M₄ ainsi que M₆ à M₈ n'ont pas été représentés. La différence D₉ entre l'échantillon acquis E₉ et la valeur modélisée M₉ est supérieure au seuil Th. Cela indique donc qu'un évènement anormal s'est produit entre l'instant t₈ et l'instant t₉. La différence D₅ entre l'échantillon acquis E₅ et la valeur modélisée M₅ est inférieure au seuil Th. Aucun évènement anormal ne s'est produit entre l'instant t₄ et l'instant t₅. Sur la figure 3, pour simplifier seules des valeurs positives ont été représentées, mais le signal peut également prendre des valeurs négatives.

Selon l'exemple illustré ici, l'événement anormal détecté est une décharge partielle. Une décharge partielle n'entraine pas à court terme de défaillance de l'appareil électrique, mais il est souhaitable de détecter l'occurrence d'un tel évènement afin d'éviter une défaillance à long terme de l'appareil électrique 2. Lorsqu'une décharge partielle est détectée, la décharge partielle a eu lieu entre l'instant tₙ et l'instant tₙ₊₁.

Selon un autre exemple de réalisation, l'évènement anormal peut être un choc mécanique affectant le fonctionnement de l'appareil. Par exemple, l'évènement anormal peut être un démarrage intempestif d'un moteur électrique, ou encore un choc mécanique provoqué par ce moteur. Cet exemple d'utilisation du procédé ne sera pas décrit ici.

Le signal vibratoire V est ici un signal de vibration représentatif d'une vibration de l'isolant 5 du conducteur électrique 1. L'isolant 5 entoure le conducteur électrique 1 et forme une gaine isolante autour de celui-ci. Le signal vibratoire est aussi appelé signal de sortie d'un capteur de vibrations 3.

Selon le mode de réalisation illustré, le capteur 3 est configuré pour fournir un signal V représentatif d'une accélération de l'isolant 5 du conducteur électrique 1. Autrement dit, le capteur 3 est un capteur d'accélération.

Comme schématisé sur la figure 2, le capteur d'accélération 3 est fixé à une surface extérieure 4 du conducteur électrique 1. Plus précisément, le conducteur électrique 1 est entouré d'un isolant 5 formant gaine, et le capteur d'accélération 3 est fixé sur la surface extérieure de l'isolant 5.

Le capteur d'accélération 3 est rigidement lié à la surface extérieure 4 du conducteur électrique 1. Autrement dit, le capteur 3 est rigidement lié à l'isolant 5. Le capteur d'accélération 3 mesure ainsi les vibrations se propageant à la surface du conducteur électrique au voisinage du capteur.

Le capteur 3 d'accélération est par exemple un capteur de type piézo-électrique. Autrement dit, le capteur 3 comprend un élément piézo-électrique, non représenté, et les vibrations mécaniques du conducteur électrique 1 modifient la pression exercée sur l'élément piézo. Une tension électrique apparait ainsi aux bornes de l'élément piézo. Cette tension électrique aux bornes de l'élément piézo-électrique est amplifiée de façon à fournir un signal de sortie exploitable. Un module électronique de traitement 6 permet de traiter le signal du capteur 3. Ce module 6 de traitement du signal peut être distinct de l'unité électronique de contrôle 10. Selon un autre exemple de mise en œuvre, le module 6 de traitement du signal peut faire partie de l'unité électronique de contrôle 10.

La bande passante du capteur 3 de vibration est comprise entre 1 kHz et 1000 kHz. Selon l'exemple illustré, le capteur 3 d'accélération délivre un signal analogique. Selon un autre exemple de mise en œuvre du procédé, le capteur 3 d'accélération délivre un signal numérique.

Un échantillon de mesure Eₙ du signal vibratoire peut correspondre par exemple à une valeur échantillonnée à un instant donné tₙ d'un capteur vibratoire. Autrement dit, un échantillon de mesure Eₙ correspond alors à une valeur instantanée du signal du capteur vibratoire.

En variante, un échantillon de mesure Eₙ du signal vibratoire peut correspondre par exemple à l'intégrale du signal instantané d'un capteur vibratoire pendant une durée prédéterminée. Autrement dit, un échantillon de mesure Eₙ correspondant alors à une valeur moyennée du signal du capteur vibratoire. La durée prédéterminée pendant laquelle le signal instantané est intégré est inférieure, ou éventuellement égale, à la période d'échantillonnage.

Selon un mode de réalisation, l'acquisition des échantillons successifs E₁, ..., Eₙ du signal vibratoire est réalisée avec une fréquence d'échantillonnage fixe.

En variante, l'acquisition des échantillons successifs E₁, ..., Eₙ du signal vibratoire peut être réalisée avec une fréquence d'échantillonnage variable. Ce cas de figure n'a pas été représenté.

Selon un mode de réalisation, la fréquence échantillonnage est comprise entre 1 kHz et 1000 kHz.

Selon un autre mode de réalisation, le signal vibratoire est un signal acoustique conduit dans l'isolant 5 du conducteur électrique 1. Les vibrations transmises par exemple par un moteur électrique alimenté par l'appareil électrique peuvent ainsi être analysées.

L'apprentissage automatique est réalisé à partir des valeurs échantillonnées du signal vibratoire.

La figure 4 illustre le signal vibratoire sur une durée d'environ 70 millisecondes. L'ensemble des points de mesure S apparait comme une bande car les espaces entre les points discrets ne sont plus visibles à cette échelle. La courbe 30 illustre la tension qui varie de manière sensiblement sinusoïdale. Les pics P₁, P₂, P₃ survenant respectivement aux instants t_{A}, t_{B}, t_{C} correspondent à des décharges partielles. Le signal de l'instant t_{D} correspond à une absence de décharge partielle. Sur cette courbe, l'ensemble des valeurs modélisées n'a pas été représenté et seul le signal brut du capteur vibratoire 3 est représenté.

Le procédé peut comporter l'étape :
- vérifier que l'ensemble Vₚ des échantillons utilisés pour l'apprentissage automatique est conforme à un fonctionnement exempt d'évènement anormal.

Cette étape optionnelle permet de vérifier que le processus d'apprentissage automatique n'est pas perturbé par des échantillons non conformes. Autrement dit, cette étape permet de vérifier que la référence utilisée est correcte.

Pendant l'acquisition des échantillons formant l'ensemble Vₚ servant à réaliser l'apprentissage automatique, une deuxième méthode de détection de l'évènement anormal est ainsi mise en œuvre simultanément. Cette deuxième méthode est basée sur un autre principe que celui utilisé par le procédé selon l'invention, et sert d'étalon de comparaison. L'instrumentation nécessaire à la mise en œuvre de cette deuxième méthode peut être installée uniquement pour l'étape de vérification de la conformité de l'ensemble Vₚ des échantillons utilisés pour l'apprentissage automatique. Par exemple, une méthode basée utilisant un signal électrique via couplage capacitif peut être mise en œuvre pour réaliser cette comparaison avec le signal vibratoire.

Selon un autre aspect, les conditions de références CRef dans lesquelles l'apprentissage automatique est réalisé sont une période de fonctionnement débutant à la première mise en service de l'appareil électrique 2 et de durée égale à une première durée d'utilisation prédéterminée D1 de l'appareil électrique 2.

Autrement dit, l'apprentissage automatique est réalisé après la première mise en service de l'appareil et pendant une première durée d'utilisation prédéterminée D1. Selon un mode de réalisation, la première durée d'utilisation prédéterminée D1 est comprise entre 10 heures et 20 heures.

Autrement dit, la première durée d'utilisation prédéterminée D1 pendant laquelle l'apprentissage automatique du bruit peut être réalisé correspond au fonctionnement à l'état neuf de l'appareil électrique 2. Pendant cette période, le fonctionnement de l'appareil électrique 2 est exempt de décharge partielle. Autrement dit, pendant cette période aucun évènement anormal indésirable ne se produit, et le signal délivré par le capteur 3 correspond au bruit résiduel de mesure. La dégradation des propriétés diélectriques de l'appareil électrique 2 étant un phénomène lent, l'état neuf de l'appareil électrique peut durer en réalité pendant plusieurs dizaines d'heures. L'apprentissage automatique peut ainsi être réalisé à n'importe quel instant compris entre l'instant de première utilisation de l'appareil et la fin de la première durée d'utilisation prédéterminée D1.

Selon un mode de réalisation, les conditions de références CRef dans lesquelles l'apprentissage automatique est réalisé sont une période de fonctionnement débutant à la première mise en service du conducteur électrique 1 et de durée égale à une deuxième durée d'utilisation prédéterminée D2 de l'appareil électrique 2.

Selon un aspect, l'apprentissage automatique est réinitialisé en cas de remplacement du conducteur électrique.

En cas de remplacement du conducteur électrique 1, par exemple lors d'une opération de maintenance suite à une détection de défaut, l'apprentissage automatique est de nouveau réalisé après le remplacement du conducteur électrique 1 et pendant une deuxième durée d'utilisation prédéterminée D2.

Autrement dit, en cas de remplacement du conducteur électrique 1, par exemple en cas de maintenance de l'appareil électrique 1, la deuxième durée prédéterminée D2 pendant laquelle l'apprentissage automatique du bruit va être réalisée correspond à l'état neuf du conducteur électrique 1 venant d'être remplacé. La dégradation des propriétés diélectriques du conducteur électrique 1 étant un phénomène lent, il est considéré que l'état neuf du conducteur électrique dure pendant plusieurs dizaines d'heures.

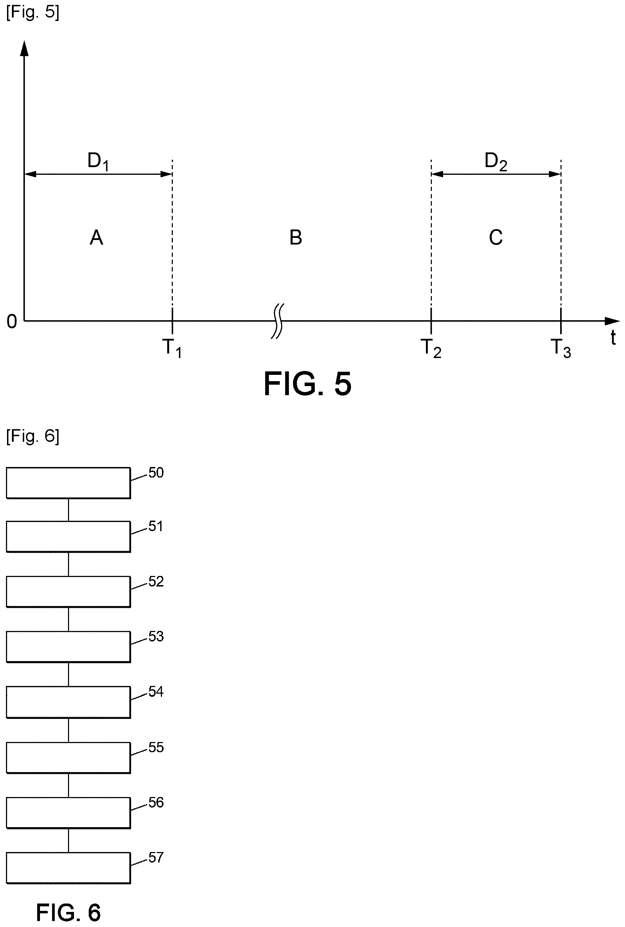

La figure 5 résume les conditions dans lesquelles l'apprentissage automatique peut être réalisé. L'instant 0 correspond à la première mise en service dans l'appareil électrique 2. L'instant T₂ correspond à la remise en service de l'appareil après un remplacement d'un conducteur électrique 1. La zone désignée par A est une zone dans laquelle l'apprentissage automatique peut être réalisé, puisque la durée de fonctionnement de l'appareil est alors inférieure à la durée prédéterminée D₁. Dans la zone désignée par B, l'apprentissage automatique ne peut plus être réalisé car la durée de fonctionnement est alors supérieure à D₁. Dans la zone désignée par C, l'apprentissage automatique est à nouveau réalisable, puisque la durée de fonctionnement depuis le remplacement du conducteur électrique 1 est inférieure à la deuxième durée D₂. Les deux traits courbes sur l'axe horizontal du temps indiquent que l'intervalle de temps compris entre T₁ et T₂ n'est pas représenté à la même échelle que les durées D₁ et D₂.

Les paramètres de l'apprentissage automatique sont mémorisés dans une mémoire permanente de l'unité électronique de contrôle 10.

La durée d'acquisition de l'ensemble Vₚ d'échantillons acquis dans des conditions de référence CRef est supérieure à 5 secondes, par exemple supérieure à 20 secondes. Cette durée d'acquisition permet d'obtenir un modèle suffisamment précis avec une durée d'apprentissage raisonnable.

Le nombre d'échantillons acquis pour réaliser l'apprentissage automatique est ainsi variable, puisqu'il dépend de la fréquence d'échantillonnage et de la durée d'acquisition. Une durée d'acquisition de 20 secondes, associée à une fréquence d'échantillonnage de 1000 kHz permet de disposer de 20 millions de points pour réaliser l'apprentissage automatique.

Selon un exemple de mise en œuvre du procédé, l'ensemble Sn d'échantillons successifs E₁, ..., Eₙ du signal vibratoire pris en compte pour déterminer une valeur modélisée Mₙ₊₁ de l'échantillon suivant Eₙ₊₁ comprend un nombre fixe d'échantillons, le nombre fixe d'échantillons étant compris entre 10 et 20.

Par exemple, la valeur modélisée de l'échantillon suivant Eₙ₊₁ est obtenue à partir des 15 échantillons préalablement acquis.

Selon un mode de réalisation, l'ensemble Sₙ d'échantillons successifs E₁, ..., Eₙ du signal vibratoire pris en compte pour déterminer une valeur modélisée Mₙ₊₁ de l'échantillon suivant Eₙ₊₁ peut comprendre un nombre variable d'échantillons compris entre 4 et 20. Autrement dit, le nombre d'échantillons successifs pris en compte pour déterminer une valeur modélisée Mₙ₊₁ de l'échantillon suivant Eₙ₊₁ peut varier au cours du temps.

Selon un mode de réalisation, le procédé comporte l'étape :
- si un événement anormal est détecté dans l'isolant 5 du conducteur électrique 1, incrémenter un compteur d'événement anormal.

Le compteur d'événement anormal est ici un compteur de décharge partielle.

Le procédé comporte l'étape :
- si le compteur d'événement anormal atteint un troisième seuil prédéterminé Nₘₐₓ, émettre un signal d'alerte.

Selon un mode de réalisation, le troisième seuil prédéterminé Nmax du nombre d'événements anormaux acceptables est égal à 1. Autrement dit, dans ce cas aucun évènement anormal n'est toléré, et les utilisateurs de l'appareil sont avertis dès la première apparition d'un évènement anormal.

En variante, le troisième seuil prédéterminé Nₘₐₓ du nombre d'événements anormaux acceptables est compris entre 2 et 5. Cette valeur permet de réaliser une confirmation de la présence d'un défaut avant l'émission d'un signal d'alerte, sans risquer un endommagement trop sévère de l'appareil.

Selon un autre mode de réalisation, le procédé comporte l'étape :
- si un événement anormal est détecté dans l'isolant 5 du conducteur électrique 1, calculer une fréquence d'apparition de l'événement anormal, la fréquence d'apparition de l'événement anormal étant égale au rapport de la valeur du compteur d'événement anormal et du nombre d'échantillons acquis.

La fréquence d'apparition de l'événement anormal peut ainsi être une fréquence de décharge partielle. Autrement dit, la fréquence d'apparition de l'évènement anormal est dans ce cas un taux d'occurrence de décharge partielle dans le conducteur électrique 1.

Selon un aspect du procédé, le procédé comporte l'étape :
- si la fréquence d'apparition de l'événement anormal atteint un deuxième seuil prédéterminé Fmax, émettre un signal d'alerte.

Selon un exemple de mise en œuvre, le signal d'alerte est un code défaut mémorisé dans une unité électronique de contrôle.

Selon une variante ou de manière complémentaire, le signal d'alerte est un allumage d'un voyant. Le signal d'alerte peut aussi être un message de type texte affiché sur un écran de contrôle.

Selon une autre variante ou de manière complémentaire, le signal d'alerte est un signal sonore.

L'utilisateur de l'appareil électrique 2 peut ainsi prendre les mesures correctives adaptées afin de minimiser les risques d'endommagement du matériel et les risques encourus par les personnes amenées à être à proximité de l'appareil électrique.

Selon un mode de réalisation, si le compteur d'événement anormal atteint le troisième seuil prédéterminé ou si la fréquence d'apparition de l'événement anormal atteint le deuxième seuil prédéterminé, un procédé de classification de l'évènement anormal est initié. Le but de ce procédé est d'identifier la classe de l'évènement anormal détecté, c'est-à-dire le type d'évènement anormal. Ce procédé ne sera pas détaillé ici.

## Revendications

1. Procédé de détection d'événement anormal dans un isolant (5) d'un conducteur électrique (1) d'un appareil électrique (2) de moyenne tension ou de haute tension,
le procédé étant mis en œuvre par une unité électronique de contrôle (10) et comportant les étapes :
- acquérir un ensemble (Sₙ) d'échantillons successifs (E₁, ..., Eₙ) d'un signal vibratoire (V) associé au conducteur électrique (1), (étape 50)
- déterminer une valeur modélisée (Mₙ₊₁) d'un échantillon suivant (Eₙ₊₁) à partir de l'ensemble (Sₙ) d'échantillons acquis et d'un modèle de prédiction, (étape 51)
le modèle de prédiction étant obtenu par apprentissage automatique du signal vibratoire (V) à partir d'un ensemble (Vₚ) d'échantillons acquis dans des conditions de référence (CRef) dans lesquelles le conducteur électrique (1) est exempt d'évènement anormal,
- acquérir l'échantillon suivant (Eₙ₊₁) du signal vibratoire (V), (étape 52)
- calculer une différence (Dₙ₊₁) entre la valeur dudit échantillon suivant acquis (Eₙ₊₁) et la valeur modélisée (Mₙ₊₁), (étape 53)
- Si la différence calculée (Dₙ₊₁) est supérieure à un seuil prédéterminé (Th), détecter un évènement anormal dans l'isolant du conducteur électrique (1). (étape 54)

2. Procédé selon la revendication 1, comportant l'étape :
- Si la différence calculée (Dₙ₊₁) est inférieure ou égale au seuil prédéterminé (Th), détecter une absence d'évènement anormal dans le conducteur électrique (1). (étape 55)

3. Procédé selon la revendication 1 ou 2, dans lequel l'événement anormal détecté est une décharge partielle.

4. Procédé selon la revendication précédente, dans lequel les conditions de références (CRef) dans lesquelles l'apprentissage automatique est réalisé sont une période de fonctionnement débutant à la première mise en service de l'appareil électrique (2) et de durée égale à une première durée d'utilisation prédéterminée (D1) de l'appareil électrique (2).

5. Procédé selon la revendication 3 ou 4, dans lequel les conditions de références (CRef) dans lesquelles l'apprentissage automatique est réalisé sont une période de fonctionnement débutant à la première mise en service du conducteur électrique (1) et de durée égale à une deuxième durée d'utilisation prédéterminée (D2) de l'appareil électrique (2).

6. Procédé selon l'une des revendications précédentes, dans lequel l'ensemble (Sₙ) d'échantillons successifs (E₁, ..., Eₙ) du signal vibratoire pris en compte pour déterminer une valeur modélisée (Mₙ₊₁) de l'échantillon suivant (Eₙ₊₁) comprend un nombre fixe d'échantillons, le nombre fixe d'échantillons étant compris entre 10 et 20.

7. Procédé selon l'une des revendications précédentes, comportant l'étape :
- si un événement anormal est détecté dans l'isolant (5) du conducteur électrique (1), incrémenter un compteur d'événement anormal.

8. Procédé selon la revendication précédente, comportant l'étape :
- si un événement anormal est détecté dans l'isolant (5) du conducteur électrique (1), calculer une fréquence d'apparition de l'événement anormal, la fréquence d'apparition de l'événement anormal étant égale au rapport de la valeur du compteur d'événement anormal et du nombre d'échantillons acquis. (étape 56)

9. Procédé selon la revendication précédente, comportant l'étape :
- si la fréquence d'apparition de l'événement anormal atteint un deuxième seuil prédéterminé (Fmax), émettre un signal d'alerte. (étape 57)

10. Appareil électrique (2) de moyenne tension ou de haute tension, l'appareil électrique (2) comportant :
- un conducteur électrique (1),
- un capteur (3) configuré pour fournir un signal (V) vibratoire associé à un isolant (5) du conducteur électrique (1)
- une unité électronique de contrôle (10) configurée pour mettre en œuvre le procédé de détection selon l'une des revendications précédentes.

11. Appareil électrique selon la revendication précédente, dans lequel le capteur (3) est configuré pour fournir un signal représentatif d'une accélération de l'isolant 5 du conducteur électrique (1).

## Patentansprüche

1. Verfahren zur Erkennung eines abnormalen Ereignisses in einer Isolierung (5) eines elektrischen Leiters (1) eines elektrischen Mittelspannungs- oder Hochspannungsgeräts (2),
wobei das Verfahren durch eine elektronische Steuereinheit (10) umgesetzt wird und die folgenden Schritte umfasst:
- Erfassen eines Satzes (Sₙ) aufeinanderfolgender Abtastungen (E₁, ..., Eₙ) eines Schwingungssignals (V), das mit dem elektrischen Leiter (1) assoziiert ist, (Schritt 50)
- Bestimmen eines modellierten Werts (Mₙ₊₁) einer nachfolgenden Abtastung (Eₙ₊₁) anhand des erfassten Satzes (Sₙ) Abtastungen und eines Vorhersagemodells, (Schritt 51)
wobei das Vorhersagemodell durch maschinelles Lernen des Schwingungssignals (V) anhand eines Satzes (Vₚ) Abtastungen erhalten wird, welcher unter Referenzbedingungen (CRef) erfasst wird, unter denen der elektrische Leiter (1) frei von einem abnormalen Ereignis ist,
- Erfassen der nachfolgenden Abtastung (Eₙ₊₁) des Schwingungssignals (V), (Schritt 52)
- Berechnen einer Differenz (Dₙ₊₁) zwischen dem Wert der erfassten nachfolgenden Abtastung (Eₙ₊₁) und dem modellierten Wert (Mₙ₊₁), (Schritt 53)
- wenn die berechnete Differenz (Dₙ₊₁) größer als ein vorbestimmter Schwellenwert (Th) ist, Erkennen eines abnormalen Ereignisses in der Isolierung des elektrischen Leiters (1). (Schritt 54)

2. Verfahren nach Anspruch 1, das den folgenden Schritt umfasst:
- wenn die berechnete Differenz (Dₙ₊₁) kleiner als oder gleich dem vorbestimmten Schwellenwert (Th) ist, Erkennen keines abnormalen Ereignisses in dem elektrischen Leiter (1). (Schritt 55)

3. Verfahren nach Anspruch 1 oder 2, wobei das erkannte abnormale Ereignis eine Teilentladung ist.

4. Verfahren nach dem vorhergehenden Anspruch, wobei die Referenzbedingungen (CRef), unter denen das maschinelle Lernen stattfindet, ein Betriebszeitraum sind, der mit der ersten Inbetriebnahme des elektrischen Geräts (2) anfängt und eine Dauer aufweist, die gleich einer ersten vorbestimmten Nutzungsdauer (D1) des elektrischen Geräts (2) ist.

5. Verfahren nach Anspruch 3 oder 4, wobei die Referenzbedingungen (CRef), unter denen das maschinelle Lernen stattfindet, ein Betriebszeitraum sind, der mit der ersten Inbetriebnahme des elektrischen Leiters (1) anfängt und eine Dauer aufweist, die gleich einer zweiten vorbestimmten Nutzungsdauer (D2) des elektrischen Geräts (2) ist.

6. Verfahren nach einem der vorhergehenden Ansprüche, wobei der Satz (Sₙ) aufeinanderfolgender Abtastungen (E₁, ..., Eₙ) des Schwingungssignals, der zum Bestimmen eines modellierten Werts (Mₙ₊₁) der nachfolgenden Abtastung (Eₙ₊₁) berücksichtigt wird, eine feste Anzahl von Abtastungen beinhaltet, wobei die feste Anzahl von Abtastungen zwischen 10 und 20 beträgt.

7. Verfahren nach einem der vorhergehenden Ansprüche, das den folgenden Schritt umfasst:
- wenn ein abnormales Ereignis in der Isolierung (5) des elektrischen Leiters (1) erkannt wird, Inkrementieren eines Zählers für abnormale Ereignisse.

8. Verfahren nach dem vorhergehenden Anspruch, das den folgenden Schritt umfasst:
- wenn ein abnormales Ereignis in der Isolierung (5) des elektrischen Leiters (1) erkannt wird, Berechnen einer Häufigkeit des Auftretens des abnormalen Ereignisses, wobei die Häufigkeit des Auftretens des abnormalen Ereignisses gleich dem Verhältnis des Werts des Zählers für abnormale Ereignisse zu der Anzahl erfasster Abtastungen ist. (Schritt 56)

9. Verfahren nach dem vorhergehenden Anspruch, das den folgenden Schritt umfasst:
- wenn die Häufigkeit des Auftretens des abnormalen Ereignisses einen zweiten vorbestimmten Schwellenwert (Fmax) erreicht, Ausgeben eines Warnsignals. (Schritt 57)

10. Elektrisches Mittelspannungs- oder Hochspannungsgerät (2), wobei das elektrische Gerät (2) Folgendes umfasst:
- einen elektrischen Leiter (1),
- einen Sensor (3), der dazu konfiguriert ist, ein Schwingungssignal (V) bereitzustellen, das mit einer Isolierung (5) des elektrischen Leiters (1) assoziiert ist,
- eine elektronische Steuereinheit (10), die dazu konfiguriert ist, das Erkennungsverfahren nach einem der vorhergehenden Ansprüche umzusetzen.

11. Elektrisches Gerät nach dem vorhergehenden Anspruch, wobei der Sensor (3) dazu konfiguriert ist, ein Signal bereitzustellen, das für eine Beschleunigung der Isolierung 5 des elektrischen Leiters (1) repräsentativ ist.

## Claims

1. Method for detecting an abnormal event in an insulator (5) of an electrical conductor (1) of a medium-voltage or high-voltage electrical device (2),
the method being implemented by an electronic control unit (10) and comprising the following steps:
- acquiring a set (Sₙ) of successive samples (E₁, ..., Eₙ) of a vibration signal (V) associated with the electrical conductor (1), (step 50)
- determining a modelled value (Mₙ₊₁) of a following sample (Eₙ₊₁) based on the acquired set (Sₙ) of samples and on a prediction model, (step 51)
the prediction model being obtained through machine learning of the vibration signal (V) based on a set (Vₚ) of samples acquired in reference conditions (CRef) in which the electrical conductor (1) is free from any abnormal event,
- acquiring the following sample (Eₙ₊₁) of the vibration signal (V), (step 52)
- calculating a difference (Dₙ₊₁) between the value of the acquired sample (Eₙ₊₁) and the modelled value (Mₙ₊₁), (step 53)
- if the calculated difference (Dₙ₊₁) is greater than a predetermined threshold (Th), detecting an abnormal event in the electrical conductor (1). (step 54)

2. Method according to Claim 1, comprising the following step:
- if the calculated difference (Dₙ₊₁) is less than or equal to the predetermined threshold (Th), detecting the absence of any abnormal event in the electrical conductor (1). (step 55)

3. Method according to Claim 1 or 2, wherein the detected abnormal event is a partial discharge.

4. Method according to the preceding claim, wherein the reference conditions (CRef) in which the machine learning is performed are an operating period starting when the electrical device (2) is first commissioned and of a duration equal to a predetermined first duration of use (D1) of the electrical device (2).

5. Method according to Claim 3 or 4, wherein the reference conditions (CRef) in which the machine learning is performed are an operating period starting when the electrical conductor (1) is first commissioned and of a duration equal to a predetermined second duration of use (D2) of the electrical device (2).

6. Method according to one of the preceding claims, wherein the set (Sₙ) of successive samples (E₁, ..., Eₙ) of the vibration signal taken into consideration to determine a modelled value (Mₙ₊₁) of the following sample (Eₙ₊₁) comprises a fixed number of samples, the fixed number of samples being between 10 and 20.

7. Method according to one of the preceding claims, comprising the following step:
- if an abnormal event is detected in the insulator (5) of the electrical conductor (1), incrementing an abnormal event counter.

8. Method according to the preceding claim, comprising the following step:
- if an abnormal event is detected in the insulator (5) of the electrical conductor (1), calculating a frequency of occurrence of the abnormal event, the frequency of occurrence of the abnormal event being equal to the ratio of the value of the abnormal event counter and the number of acquired samples. (step 56)

9. Method according to the preceding claim, comprising the following step:
- if the frequency of occurrence of the abnormal event reaches a predetermined second threshold (Fmax), emitting an alert signal. (step 57)

10. Medium-voltage or high-voltage electrical device (2), the electrical device (2) comprising:
- an electrical conductor (1),
- a sensor (3) configured to supply a vibration signal (V) associated with an insulator (5) of the electrical conductor (1),
- an electronic control unit (10) configured to implement the detection method according to one of the preceding claims.

11. Electrical device according to the preceding claim, wherein the sensor (3) is configured to supply a signal representative of an acceleration of the insulator (5) of the electrical conductor (1).
